# FASCICULE DE BREVET EUROPEEN

(11) **EP 4 657 679 B1**
(45) Date de publication et mention de la délivrance du brevet: **18.11.2026**
(21) Numéro de dépôt: 25177521.9
(22) Date de dépôt: 20.05.2025
(51) Int. Cl.: H01S 5/02, H01S 5/026, H01S 5/10, H01S 5/12, H01S 5/125, H01S 5/14, H01S 5/22

(54) **LASER À CASCADE QUANTIQUE ÉMETTANT DANS L`INFRAROUGE MOYEN**
QUANTENKASKADENLASER IM MITTLEREN INFRAROTBEREICH
MID-INFRARED QUANTUM CASCADE LASER

(30) Priorité: 31.05.2024 FR 2405732
(43) Date de publication de la demande: 03.12.2025
(73) Titulaire: Commissariat à l'Energie Atomique et aux Energies Alternatives, 75015 Paris (FR)
(72) Inventeur: LEPAGE, Maxime, 38054 Grenoble Cedex 09 (FR); BEN BAKIR, Badhise, 38054 Grenoble Cedex 09 (FR)
(74) Mandataire: Santarelli

(56) Documents cités:
- EP-A1- 3 352 312
- EP-B1- 3 793 045
- US-A1- 2020 185 885
- US-B2- 11 211 773

## Description

### DOMAINE TECHNIQUE

Le domaine de l'invention est celui des lasers à cascade quantique émettant dans l'infrarouge moyen, par exemple dans la gamme de longueurs d'onde comprises entre 3 µm et 15 µm. L'invention concerne par exemple un capteur de gaz comprenant un tel laser à cascade quantique.

### ÉTAT DE LA TECHNIQUE ANTÉRIEURE

Les lasers à cascade quantique sont couramment utilisés dans des systèmes de détection de gaz, par exemple un capteur de gaz à infrarouge non dispersif ou un spectromètre photo-acoustique. Chaque laser à cascade quantique émet alors généralement un flux lumineux à une longueur d'onde absorbée par un gaz que l'on cherche à détecter. La gamme de longueurs d'onde d'intérêt pour cette application est l'infrarouge moyen s'étendant de 3 µm à 15 µm, et plus particulièrement la gamme de longueurs d'onde s'étendant de 4 µm à 15 µm.

Il existe des lasers à cascade quantique de type à rétroaction distribuée, appelé DFB (pour Distributed Feedback en anglais), Un laser à cascade quantique DFB comprend généralement un milieu amplificateur en matériaux III-V. Le milieu amplificateur comporte une région active composée d'une alternance de puits quantiques et de barrières, par exemple en InGaAs pour les puits et AllnAs pour les barrières. Le milieu amplificateur a des dimensions géométriques et des indices de réfraction autorisant le guidage d'un mode optique laser à une longueur d'onde d'émission le long d'un axe optique du milieu amplificateur. En fonctionnement, la différence d'énergie entre deux bandes de conduction de deux puits adjacents de la région active est telle qu'un électron émet un photon à la longueur d'onde d'émission en passant de l'une à l'autre, ceci de façon à exciter le mode optique laser. Les puits quantiques s'étendent parallèlement à un plan contenant l'axe optique. Le photon est polarisé perpendiculairement aux puits quantiques, il en est par conséquent de même du mode optique laser.

Dans un plan de coupe perpendiculaire aux puits quantiques, le mode laser est guidé par une couche de confinement inférieure et une couche de confinement supérieure agencées de part et d'autre de la région active. Les couches de confinement inférieure et supérieure ont chacune un indice de réfraction inférieur à un indice de réfraction minimal de la région active. Elles sont en un matériau semiconducteur dopé pour transporter les électrons vers ou depuis la région active. Elles ont par conséquent une double fonction et sont généralement en InP dopée N.

Un réseau satisfaisant à la condition de Bragg à la longueur d'onde d'émission est structuré dans ou sur le milieu amplificateur de façon à diffracter le mode optique laser pour lui faire parcourir des aller-retours au sein du milieu amplificateur. Un faisceau laser est émis par une face latérale du milieu amplificateur orthogonale aux puits quantiques et à l'axe optique. Il a une dimension supérieure ou égale à la longueur d'onde d'émission au niveau de la face latérale. Le milieu amplificateur peut avoir des dimensions transversales de l'ordre de deux fois la longueur d'onde d'émission. La longueur du milieu amplificateur le long de l'axe optique est suffisante pour obtenir la puissance du faisceau laser souhaitée.

Pour des applications particulières, comme la détection de gaz, il est souvent nécessaire de coupler optiquement un ou plusieurs lasers à cascade quantique à un circuit photonique intégré assurant des fonctions optiques. Pour un spectromètre photo-acoustique, il peut par exemple être nécessaire de multiplexer les faisceaux laser émis à des longueurs d'onde d'émission différentes par plusieurs lasers à cascade quantique, en entrée d'une chambre contenant un gaz à analyser. Le multiplexage peut se faire par un réseau de guides d'ondes (ou Arrayed Waveguide Grating, AWG, en anglais).

Un circuit photonique intégré conventionnel comporte des guides d'onde en silicium, encapsulés dans des couches en oxyde de silicium. Cependant l'oxyde de silicium ne transmet pas ou peu la lumière dans la gamme de longueurs d'onde d'intérêt. Il n'est donc pas possible de coupler optiquement un laser à cascade quantique émettant un faisceau laser dans l'infrarouge moyen à un circuit photonique conventionnel.

Il est connu de coupler un laser à cascade quantique à un circuit photonique par un coupleur par la tranche du circuit photonique, c'est-à-dire par une face latérale du coupleur par la tranche et d'une puce photonique comprenant le circuit photonique. Le coupleur par la tranche comporte un guide d'onde couplé optiquement à d'autres guides d'onde et/ou des composants optiques du circuit photonique. Tous les guides d'onde du circuit photonique sont réalisés dans un ou des matériaux identiques. Puisque le faisceau laser émis dans la gamme de longueurs d'onde d'intérêt est de grande taille, il est nécessaire d'utiliser des guides d'onde ayant un faible contraste d'indice de réfraction entre leur coeur et leurs couches de confinement. Tous les guides d'onde du circuit photonique ont en général un coeur en germanium et une ou des couches de confinement en silicium-germanium. Ces matériaux ne sont pas standard dans le domaine de la photonique intégrée. De plus, le faible contraste d'indice de réfraction implique que les guides d'onde sont imposants et faiblement courbés. La puce photonique est par conséquent de grande dimension. Lorsqu'elle fait partie d'un capteur de gaz, la chambre contenant les gaz à analyser est dimensionnée en proportion de la taille des guides d'onde. Elle est donc, elle aussi, imposante.

Il existe donc un besoin pour coupler optiquement des lasers à cascade quantique émettant dans la gamme de longueurs d'onde d'intérêt à une puce photonique comprenant des guides d'onde à plus fort contraste d'indice de réfraction et transparents à des longueurs d'onde comprises dans l'infrarouge moyen.

Dans le domaine des communications de données entre puces, dit des « datacom », et celui des télécommunications, dit des « télécom », il est connu de coupler optiquement un milieu amplificateur en matériaux III-V à un circuit photonique conventionnel par couplage évanescent avec un guide d'onde principal en silicium du circuit photonique. Le guide d'onde principal comporte un réseau dans une section de couplage du guide d'onde principal, apte à réaliser une rétroaction distribuée dans le milieu amplificateur à une longueur d'onde d'émission comprise dans une gamme de longueurs d'onde de photoluminescence du milieu amplificateur. Le guide d'onde principal comprend en outre une section de transition modale assurant un couplage adiabatique du mode laser vers une section de propagation du guide d'onde principal. La section de propagation n'est pas en regard du milieu amplificateur. Elle est couplée optiquement à un ou plusieurs composants du circuit photonique. Le circuit photonique est une partie d'une puce photonique. L'ensemble comprenant le milieu amplificateur et le guide d'onde principal sont des éléments d'un laser hybride intégré dans la puce photonique, c'est-à-dire que le laser hybride est une partie intégrante de la puce photonique.

Un exemple de laser intégré dans une puce photonique particulièrement avantageux pour des applications « datacom » ou « télécom », est décrit dans le document EP3793045 A1. Dans celui-ci, le milieu amplificateur comprend un empilement de puits quantiques intercalé entre une couche de confinement supérieure dopée P, et une couche de confinement inférieure dopée N. Le milieu amplificateur est collé sur un substrat s'étendant selon un plan principal. Les puits quantiques s'étendent parallèlement au plan principal. Un guide d'onde optique comporte une section de couplage en regard du milieu amplificateur, une section de propagation qui n'est pas en vis-à-vis du milieu amplificateur et une section de transition modale s'étendant depuis la section de couplage jusqu'à la section de propagation. Le guide d'onde s'étend parallèlement au plan principal. Une couche de liaison en oxyde de silicium sépare le milieu amplificateur de la section de couplage. La section de couplage comprend un réseau de diffraction.

En fonctionnement, un électron se recombine à un trou dans un puit quantique pour émettre un photon polarisé parallèlement aux puits quantiques et au plan principal. Le guide d'onde est dimensionné par rapport au milieu amplificateur de telle sorte que le photon polarisé excite un supermode antisymétrique, ou impair, de la structure composée du milieu amplificateur et de la section de couplage. Etant donné la polarisation du photon, le supermode antisymétrique est de type transverse électrique (TE). La section de transition modale se rétrécit progressivement de la section de couplage à la section de propagation de façon à assurer une conversion modale entre le supermode antisymétrique et un mode optique se propagent dans la section de propagation. Le mode optique a par conséquent la même polarisation que le supermode antisymétrique, c'est-à-dire une polarisation de type transverse électrique (TE).

### EXPOSÉ DE L'INVENTION

L'invention a pour objectif de remédier au moins en partie aux inconvénients de l'art antérieur, et plus particulièrement de proposer un laser à cascade quantique intégré, le laser émettant un mode optique polarisé de type transverse magnétique (TM) à une longueur d'onde λ comprise entre 3 µm et 15 µm.

Pour cela, l'objet de l'invention est un laser à cascade quantique pour émettre un mode optique polarisé de type transverse magnétique à une longueur d'onde λ comprise entre 3 µm et 15 µm, comportant un milieu amplificateur semiconducteur comportant une région active, un guide d'onde principal s'étendant parallèlement à la région active. Le guide d'onde principal comporte une section de couplage en contact avec le milieu amplificateur, comprenant un réseau de diffraction configuré pour générer une rétroaction distribuée dans le milieu amplificateur à la longueur d'onde λ, et une section de propagation séparée du milieu amplificateur, apte à guider le mode optique. Le laser à cascade quantique est tel que la section de couplage a une largeur W supérieure ou égale à une largeur minimale Wmin à partir de laquelle un supermode antisymétrique se propageant dans une structure de guidage du laser comprenant le milieu amplificateur et le guide d'onde principal, a un facteur de confinement dans la région active strictement supérieur aux facteurs de confinement dans la région active des modes optiques susceptibles d'être guidés par la structure de guidage. Le laser à cascade quantique est tel que le guide d'onde principal comporte un cœur en un matériau à base d'atomes de la colonne IV A du tableau périodique des éléments et une sous-couche de confinement en nitrure de silicium ou en un chalcogénure, d'un côté du guide d'onde principal opposé au milieu amplificateur.

Certains aspects préférés mais non limitatifs de ce laser à cascade quantique sont les suivants.

Le guide d'onde principal peut comporter en outre une section de transition modale en contact avec le milieu amplificateur, s'étendant de la section de couplage à la section de propagation. La section de transition modale peut se rétrécir progressivement de la section de couplage à la section de propagation de façon à assurer une conversion modale entre le supermode antisymétrique et le mode optique.

Le milieu amplificateur peut comprendre une portion semiconductrice inférieure en contact avec le guide d'onde principal et une portion semiconductrice supérieure, toutes deux dopées N. La région active peut être intercalée entre les portions semiconductrices inférieure et supérieure.

La région active et la portion semiconductrice supérieure peuvent avoir, chacune et ensemble, une forme de parallélépipède droit.

Le réseau de diffraction peut comporter des dents, chacune de profondeur hr, la largeur W et la profondeur hr pouvant être telles que le réseau de diffraction présente une force de couplage Kr comprise entre 5 cm⁻¹ et 100 cm⁻¹, de préférence comprise entre 10 cm⁻¹ et 28 cm⁻¹.

Le réseau de diffraction peut comporter des dents, chacune de profondeur hᵣ, la profondeur hᵣ pouvant être supérieure à une profondeur minimale h_{r,min} permettant de contenir une variation d'une force de couplage Kᵣ du réseau de diffraction en fonction de hᵣ dans une plage de variation acceptable déterminée pour garantir le respect d'une spécification du laser à cascade quantique.

Un capteur de gaz peut comprendre une puce photonique, une chambre couplée optiquement à la puce photonique, la puce photonique pouvant comprendre un laser à cascade quantique selon l'une quelconque des caractéristiques précédentes, intégré dans la puce photonique.

Le laser à cascade quantique peut être un élément d'une matrice de plusieurs lasers à cascade quantique selon l'une quelconque des caractéristiques précédentes, chaque laser à cascade quantique de la matrice pouvant être configuré pour émettre un mode optique à une longueur d'onde λᵢ différente des longueurs d'ondes des modes optiques émis par les autres lasers à cascade quantique de la matrice.

La puce photonique peut comporter un multiplexeur de longueurs d'onde et une couche structurée. Chaque section de propagation d'un laser à cascade quantique de la matrice peut être connectée optiquement à une entrée distincte du multiplexeur. Le multiplexeur peut comprendre un guide d'onde de sortie couplé optiquement à chacune des entrées du multiplexeur et à la chambre. La couche structurée peut comprendre le multiplexeur, le guide d'onde de sortie et chacun des guides d'onde principaux des laser à cascade quantique de la matrice.

La couche structurée peut comprendre en outre une partie au moins de la chambre.

La chambre peut être une cellule photo-acoustique à résonnance différentielle de Helmholtz.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1A est une vue schématique de dessus d'un laser à cascade quantique selon l'invention ;
la figure 1B est une vue schématique en coupe longitudinale du laser ;
la figure 1C est une vue schématique en coupe transversale du laser ;
la figure 2 est une vue schématique de dessus d'un capteur de gaz mettant en œuvre une matrice de lasers à cascade quantique selon l'invention ;
la figure 3 est un graphique montrant des évolutions d'indices de réfraction effectif de modes de type transverse magnétique (TM) guidés dans des guides d'onde respectifs, en fonction de la largeur des guides d'onde ;
la figure 4 est un graphique montrant des évolutions du confinement de supermodes du laser, en fonction de la largeur d'un guide d'onde principal du laser ;
la figure 5 est un graphique montrant des évolutions de la force de couplage de supermodes du laser avec un réseau de diffraction du laser, en fonction de la largeur du guide d'onde principal ;
la figure 6 est un graphique montrant des évolutions de la force de couplage d'un supermode antisymétrique du laser avec le réseau de diffraction, en fonction d'une profondeur de dent du réseau de diffraction.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un laser à cascade quantique émettant un mode optique polarisé de type transverse magnétique à une longueur d'onde λ comprise dans la gamme de longueurs d'onde d'intérêt. Il comporte un milieu amplificateur semiconducteur en contact avec un guide d'onde principal du laser. Le guide d'onde principal a une section de couplage comprenant un réseau de diffraction, en contact avec le milieu amplificateur. Il a une section de propagation qui n'est pas en regard du milieu amplificateur et une section de transition modale intercalée entre la section de couplage et la section de propagation.

La section de couplage et le milieu amplificateur ont des dimensions permettant de guider un supermode à la longueur d'onde λ dans une structure de guidage comprenant le milieu amplificateur et la section de couplage. Un pas du réseau de diffraction satisfait à la condition de Bragg pour la longueur d'onde λ. Il est agencé par rapport au milieu amplificateur de façon à créer une cavité optique par un phénomène de rétroaction distribuée. Ainsi, le milieu amplificateur n'est pas séparé de la section de couplage par une couche de liaison, et le laser à cascade quantique est un laser DFB intégré, ne comprenant pas de couche absorbante dans sa cavité optique.

La section de couplage a de plus une largeur supérieure à une largeur minimale identifiée par les inventeurs à partir de laquelle le supermode est un supermode antisymétrique. Cela permet de garantir un bon rapport de suppression des modes latéraux (ou SMSR pour Side Mode Suppression Ratio, en anglais).

Dans la description, il est donné à « supermode symétrique » et à « supermode antisymétrique » leurs sens communs dans le domaine technique. Par soucis de clarté, il est toutefois précisé qu'un supermode antisymétrique, appelé aussi parfois supermode impair, est un mode optique particulier se propageant selon un axe optique dans une structure de guidage comportant deux guides d'onde parallèles entre eux, tel que, dans tout plan orthogonal à l'axe optique, le champ électrique du mode optique dans un des guides d'onde est déphasé de π par rapport au champ électrique du mode optique dans l'autre guide d'onde. Un supermode symétrique, appelé aussi parfois supermode pair, est un mode optique particulier se propageant selon un axe optique dans une structure de guidage comportant deux guides d'onde parallèles entre eux, tel que, dans tout plan orthogonal à l'axe optique, le champ électrique du mode optique dans un des guides d'onde est en phase avec le champ électrique du mode optique dans l'autre guide d'onde.

Le SMSR (Side Mode Suppression Ratio), ou Rapport de Suppression des Modes Latéraux, d'un laser à rétroaction distribuée (DFB pour Distributed Feedback) est une mesure de la capacité du laser à supprimer les modes latéraux par rapport au mode principal de l'émission laser. Il est égal au rapport de l'intensité du mode principal sur l'intensité du mode latéral de plus forte intensité. Il est généralement exprimé en décibels (dB).

Dans toute la description, un guide d'onde est un guide d'onde monomode ou multimode apte à confiner la lumière, par opposition aux guides optiques à l'intérieur desquels la lumière se propage par réflexion totale interne. Sans plus de précisions, un guide d'onde peut être de type quelconque. Cela peut par exemple être un guide ruban, en arête ou planaire. Un guide d'onde a un cœur et, éventuellement, une ou plusieurs couches de confinement entourant le cœur de façon à être en contact physique avec le cœur. Un contraste ou une variation d'indices de réfraction entre d'une part le cœur et d'autre part, la ou les couches de confinement ou un gaz ou du vide, permet de confiner la lumière. Les guides d'onde sont repérés par leurs cœurs sur les figures. De même, sans plus de précision, un indice de réfraction d'un guide d'onde est un indice de réfraction du cœur du guide d'onde ; une distance séparant deux guides d'onde est la distance séparant les cœurs des guides d'onde respectifs ; le matériau d'un guide d'onde est le matériau du cœur du guide d'onde ; lorsqu'un guide d'onde s'étend selon une direction, on entend que le cœur du guide d'onde s'étend selon cette direction ; lorsqu'un guide d'onde est en contact avec une couche, on entend que le cœur du guide d'onde est en contact avec la couche.

Par couche, on entend ici et pour la suite de la description, une étendue constituée d'une ou plusieurs sous-couches d'un matériau dont l'épaisseur suivant un axe z est inférieure, par exemple dix fois, voire vingt fois, à ses dimensions longitudinales de largeur et de longueur dans un plan xy perpendiculaire à l'axe z. Une couche peut être structurée. Lorsqu'elle consiste en plusieurs sous-couches, les sous-couches peuvent être en des matériaux différents. La ou les sous-couches s'étendent dans des plans sensiblement parallèles au plan xy. Lorsqu'une couche est en un type de matériau particulier ou en un matériau particulier, elle peut comprendre plusieurs sous-couches, toutes, respectivement, du type de matériau ou du matériau.

Dans toute la description, deux composants optiques sont dits couplés optiquement lorsqu'un mode optique peut se propager au moins en partie dans les deux composants optiques, éventuellement via des composants optiques intermédiaires. Le couplage peut se faire de différente façon, par exemple via un couplage direct, un réseau de diffraction, un couplage adiabatique, ou évanescent, ou directionnel, ...

Des modes de réalisation particuliers vont être décrits se rapportant à un laser à cascade quantique intégré de type DFB. Cependant, ces modes de réalisation peuvent être adaptés à d'autres types de lasers intégrés, comme par exemple un laser à cascade quantique de type DBR (ou Distributed Bragg Reflector, en anglais).

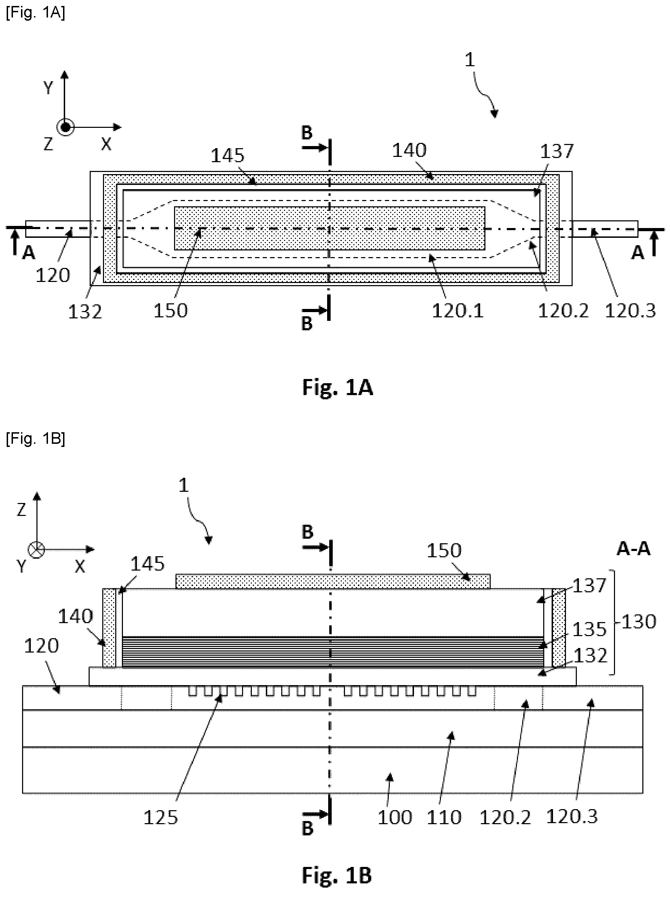

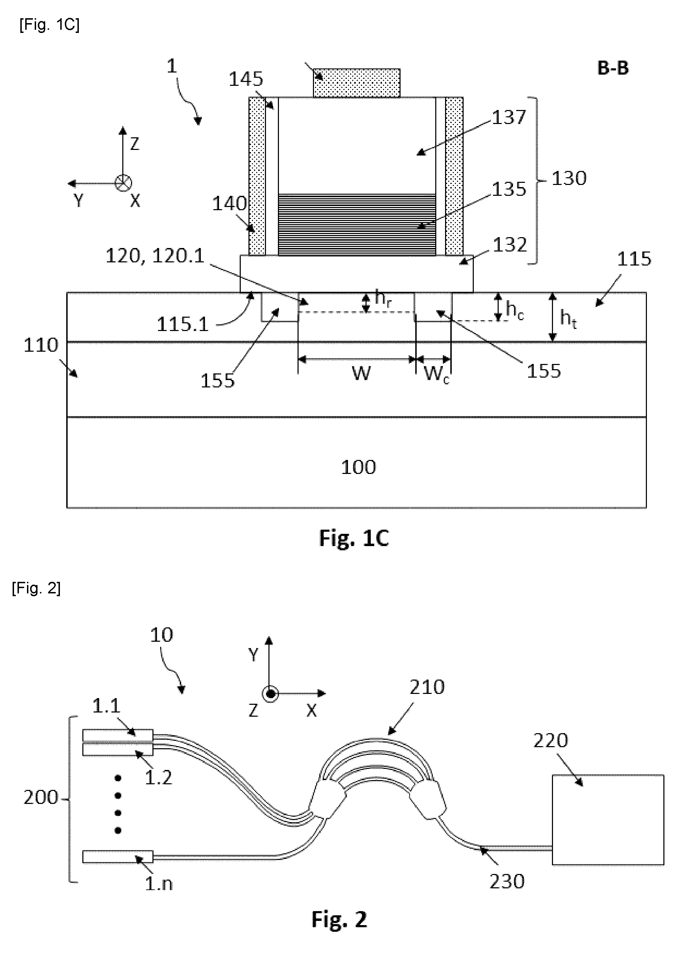

Les figures 1A, 1B et 1C sont des vues d'un laser à cascade quantique 1 selon l'invention. La figure 1A est une vue de dessus sur laquelle figurent le plan de coupe A-A de la figure 1B, et le plan de coupe B-B de la figure 1C.

Le laser à cascade quantique 1 est configuré pour émettre un mode optique polarisé à une longueur d'onde λ. Il comporte un substrat 100, un guide d'onde principal 120 et un milieu amplificateur 130. Le substrat 100 a une face supérieure sensiblement plane.

On définit ici et pour la suite de la description un repère direct tridimensionnel orthogonal (X, Y, Z), où les axes X et Y forment un plan parallèle à la face supérieure du substrat 100, l'axe X étant orienté dans le plan de coupe A-A, et où l'axe Z est orienté de manière sensiblement orthogonale à la face supérieure du substrat 100, depuis la face supérieure vers le milieu amplificateur 130. Dans la suite de la description, les termes « vertical » et « verticalement » s'entendent comme étant relatifs à une orientation sensiblement parallèle à l'axe Z, et les termes « horizontal » et « horizontalement » comme étant relatifs à une orientation sensiblement parallèle au plan (X, Y). Par ailleurs, les termes « inférieur » et « supérieur » s'entendent comme étant relatifs à un positionnement croissant lorsqu'on s'éloigne du substrat 100 suivant la direction +Z. Le terme « latéral » se réfère à une orientation sensiblement parallèle à l'axe Z.

Le substrat 100 peut être issu d'une plaque en un matériau semiconducteur, après avoir subi éventuellement une étape de découpe et/ou d'amincissement. Dans cet exemple, le substrat 100 est en silicium.

Une couche d'encapsulation inférieure 110 est en contact avec la face supérieure du substrat 100. D'un côté opposé au substrat 100, elle a une face supérieure sensiblement plane et parallèle à la face supérieure du substrat 100. Le guide d'onde principal 120 s'étend selon un premier axe sur la face supérieure de la couche d'encapsulation inférieure 110, en contact avec une sous-couche de confinement de la couche d'encapsulation inférieure 110. Ici, le premier axe est rectiligne et parallèle à X. Dans cet exemple, le plan de coupe B-B est un plan de symétrie du guide d'onde principal 120.

La sous-couche de confinement est en un matériau transparent à la longueur d'onde λ. Elle est par exemple en un matériau diélectrique. La couche d'encapsulation inférieure 110 peut comprendre ou ne pas comprendre des sous-couches additionnelles. Le cas échéant les sous-couches additionnelles peuvent être de nature quelconque. Dans cet exemple, la sous-couche de confinement est en nitrure de silicium (SiN) ou en un chalcogénure en phase amorphe. Ici, la couche d'encapsulation inférieure 110 comprend une sous-couche additionnelle en contact avec la sous-couche de confinement et le substrat 100, en oxyde de silicium.

Le guide d'onde principal 120 est en un matériau transparent à la longueur d'onde λ, par exemple en un matériau semiconducteur dont l'énergie de gap est supérieure à l'énergie de photons à la longueur d'onde λ. Le matériau semiconducteur peut être à base d'atomes de la colonne IV A du tableau périodique des éléments, c'est-à-dire qu'il comprend au moins 90 % d'atomes de la colonne IV A, préférentiellement au moins 99 %. Il peut par exemple être du silicium, du silicium-germanium ou du germanium. Le guide d'onde principal 120 est ici une partie d'une couche structurée 115 en silicium, qui est le matériau conventionnel utilisé en photonique sur silicium dans le domaine des « datacom » ou des « télécom ». Il a une épaisseur mesurée parallèlement à l'axe Z, préférentiellement constante, comprise entre 0,5 µm et 5 µm, par exemple égale à 2,6 µm. Dans cet exemple, le guide d'onde principal 120 est un guide en arête. Ici, l'arête est au moins en partie délimitée latéralement, dans un plan parallèle au plan (X, Y) par deux cavités longilignes 155.

Le milieu amplificateur 130 est en vis-à-vis des cavités longilignes 155. Les cavités longilignes 155 s'étendent parallèlement au plan (X, Y), préférentiellement au-delà de deux faces latérales du milieu amplificateur 130, opposées et perpendiculaire à l'axe X.. Il est en contact avec des surfaces d'appuis 115.1 de la couche structurée 115, situées de part et d'autre du guide d'onde principal 120. Les cavités longilignes 155 s'étendent en profondeur dans la couche structurée 115 depuis les surfaces d'appuis 115.1, sur une profondeur h_{c} sensiblement constante. Elles ont une largeur W_{c} mesurée parallèlement au plan (X, Y) et perpendiculairement au premier axe. Elles sont remplies d'un matériau transparent à la longueur d'onde λ, d'indice de réfraction strictement inférieure à un indice de réfraction du guide d'onde principal 120. Elles sont, dans cet exemple, remplies d'air.

Le guide d'onde principal 120 comporte une section de couplage 120.1, une section de transition modale 120.2 et une section de propagation 120.3. La section de couplage 120.1 a une face supérieure sensiblement plane et parallèle au plan (X, Y). Elle est en contact avec le milieu amplificateur 130 sur toute sa face supérieure. Elle a deux flancs opposés parallèles au premier axe, ici sensiblement orthogonaux au plan (X, Y). La face supérieure de la section de couplage 120.1 joint les flancs entre eux. La section de couplage 120.1 a une largeur W mesurée parallèlement à l'axe Y. Les largeurs W et W_{c}, ainsi que les matériaux respectifs du guide d'onde principal 120 et des cavités longilignes 155 permettent de confiner la lumière à la longueur d'onde λ. Ici, la largeur W est la largeur de l'arête du guide d'onde principal 120 au niveau de la section de couplage 120.1. Elle est égale à la distance séparant les deux flancs opposés. Dans cet exemple, la largeur W est sensiblement constante et égale à la distance séparant les cavités longilignes 155.

La section de propagation 120.3 a des dimensions permettant la propagation du mode optique polarisé. Elle est séparée du milieu amplificateur 130, c'est-à-dire que le milieu amplificateur 130 ne recouvre pas une partie au moins de la section de propagation 120.3, et n'est donc pas en contact avec elle au niveau de cette partie.

La section de transition modale 120.2 s'étend parallèlement au plan (X, Y) depuis la section de couplage 120.1 jusqu'à la section de propagation 120.3. Dans un plan parallèle au plan (X, Y), la section de transition modale 120.2 se rétrécit progressivement depuis la section de couplage 120.1 vers la section de propagation 120.3. De préférence, elle a une largeur horizontale égale à W au niveau d'une position proximale en contact avec la section de couplage 120.1. Elle est au moins en partie en vis-à-vis du milieu amplificateur 130. La section de propagation 120.3 et la section de transition modale 120.2 ont préférentiellement des largeurs horizontales identiques au niveau d'une position distale de la section de transition modale 120.2 en contact avec la section de propagation 120.3.

Le milieu amplificateur 130 s'étend selon un deuxième axe parallèle au premier axe et au plan (X, Y). Les premier et deuxième axes définissent un plan coplanaire avec le plan de coupe A-A. Le plan de coupe A-A est dans cet exemple, un plan de symétrie du guide d'onde principal 120 et du milieu amplificateur 130. Dans cet exemple, le plan de coupe B-B est un plan de symétrie du milieu amplificateur 130.

Le milieu amplificateur 130 comporte une portion semiconductrice inférieure 132, une portion semiconductrice supérieure 137 et une région active 135 intercalée entre les portions semiconductrices inférieure et supérieure 132, 137. La région active 135 comporte des puits quantiques s'étendant parallèlement au plan (X, Y). Les portions semiconductrices inférieure et supérieure 132, 137 sont ici dopées de type N. Elles sont en un matériau semiconducteur cristallin, dans cet exemple en phosphure d'indium (InP). Ici, la région active 135 et la portion semiconductrice supérieure 137 ont, sensiblement, chacune et ensemble, une forme de parallélépipède droit. Elles ont une largeur Wₐ mesurée parallèlement à l'axe Y.

La région active 135 recouvre ici partiellement la portion semiconductrice inférieure 132. De préférence, la portion semiconductrice inférieure 132 recouvre entièrement la partie des cavités longilignes 155 en regard du milieu amplificateur 130. Une électrode inférieure 140 est en contact avec une surface supérieure de la portion semiconductrice inférieure 132, non recouverte par la région active 135. Ici, l'électrode inférieure 140 entoure la région active 135 et la portion semiconductrice supérieure 137. Elle est isolée électriquement de la région active 135 et de la portion semiconductrice supérieure 137 par un revêtement isolant 145 intercalée entre d'un côté l'électrode inférieure 140 et d'un autre, la région active 135 et la portion semiconductrice supérieure 137. Le revêtement isolant 145 est avantageusement une couche de passivation de la région active 135 et/ou de la portion semiconductrice supérieure 137.

Une électrode supérieure 150 est en contact avec une face supérieure de la portion semiconductrice supérieure 137. L'électrode inférieure 140 et le revêtement isolant 145 affleurent, ici, la face supérieure de la portion semiconductrice supérieure 137. Les électrodes inférieure et supérieure 140, 150 sont en un matériau conducteur de l'électricité, par exemple en métal.

La région active 135 est préférentiellement une alternance de puits quantiques et de barrières, par exemple entre 20 et 50 puits intercalés entre deux barrières. Les puits peuvent être en InGaAs en combinaison avec des barrières en AllnAs, ou en AlAsSb. Alternativement, les puits peuvent être en InAs avec des barrières en AlSb, et de préférence, une portion semiconductrice inférieure 132 et/ou une portion semiconductrice supérieure 137 en InAs ou en GaAs. Dans tous les cas, deux ou plusieurs puits (barrières) peuvent être réalisé(e)s dans un même alliage semiconducteur mais avoir des concentrations atomiques d'un élément de l'alliage différentes. La région active 135 a par exemple, une longueur le long de l'axe X comprise entre 0,5 mm et 3 mm. Elle a par exemple une hauteur mesurée le long de l'axe Z comprise entre 1,2 µm et 3 µm. Elle a de préférence une largeur inférieure ou égale à 4λ. De préférence, la largeur est supérieure ou égale à λ.

La portion semiconductrice inférieure 132 a une épaisseur suffisamment faible pour permettre un couplage évanescent et suffisamment grande pour une bonne tenue mécanique à l'aplomb des cavités longilignes 155. Elle peut être comprise entre λ/10 et λ/5 , par exemple égale à 350 nm lorsque la longueur d'onde λ est égale à 4,5 µm.

La portion semiconductrice supérieure 137 a une épaisseur suffisante pour qu'en fonctionnement, un mode de cavité du laser à cascade quantique 1, amplifié par le milieu amplificateur 130, n'interagisse pas avec l'électrode supérieure 150. Elle a par exemple une épaisseur comprise entre λ/4 et λ.

La section de couplage 120.1 comporte un réseau de diffraction 125. Le réseau de diffraction 125 est un réseau périodique satisfaisant à la condition de Bragg à la longueur d'onde λ. Il peut comprendre un saut de phase dans une région centrale du réseau de diffraction 125, par exemple égale à π ou π/2. Le réseau de diffraction 125 est configuré pour générer une rétroaction distribuée dans le milieu amplificateur 130, c'est-à-dire qu'un mode ou un supermode à la longueur d'onde λ guidé par le milieu amplificateur 130, interagissant avec le réseau de diffraction 125, fait en partie des aller-retours sur une longueur du milieu amplificateur 130 définissant une cavité optique du laser à cascade quantique 1.

Dans cet exemple, le réseau de diffraction 125 comporte une succession de dents s'étendant perpendiculairement au premier axe, préférentiellement sur toute la largeur W de la section de couplage 120.1. Chaque dent a sensiblement la forme d'un parallélépipède droit. Elles s'étendent en profondeur dans la section de couplage 120.1, depuis la face supérieure de la section de couplage 120.1, sur une profondeur hᵣ, pouvant être égale à h_{c}. Sur la figure 1C, on a représenté en pointillés un bord inférieur d'une dent.

La largeur W de la section de couplage 120.1 est supérieure ou égale à une largeur minimale Wₘᵢₙ à partir de laquelle un supermode antisymétrique se propageant dans une structure de guidage comprenant le milieu amplificateur 130 et le guide d'onde principal 120, a un facteur de confinement dans la région active 135 strictement supérieur aux facteurs de confinement dans la région active 135 des modes optiques susceptibles d'être guidés par la structure de guidage.

En fonctionnement, la différence d'énergie entre les bandes de conduction de deux puits quantiques contigus est égale à l'énergie d'un photon à la longueur d'onde λ. Ainsi, un photon incident du supermode antisymétrique induit le passage d'un électron entre les deux puits quantiques. Un photon supplémentaire est alors émis par un phénomène d'émission stimulée. Les photons, incident supplémentaire, ont la même énergie, la même phase et la même direction de polarisation, perpendiculaire aux puits quantiques.

Le supermode antisymétrique est guidé par la structure de guidage. Il est progressivement diffracté par le réseau de diffraction 125 de façon à faire des aller-retours sur une longueur de la structure de guidage définissant la cavité optique. La section de transition modale 120.2 se rétrécit progressivement de la section de couplage 120.1 à la section de propagation 120.3 de façon à transférer une partie de l'énergie du supermode antisymétrique au mode guidé polarisé, guidé par la section de propagation 120.3. Ainsi, la section de transition modale 120.2 a une fonction de conversion modale entre le supermode antisymétrique et le mode guidé polarisé. Ici, la section de transition modale 120.2 participe au couplage adiabatique entre le supermode antisymétrique et le mode optique polarisé. Le mode guidé polarisé a sa polarisation orientée dans la même direction que celle du supermode antisymétrique, il s'agit donc d'un mode optique de type transverse magnétique (TM).

Une diminution de l'épaisseur de la portion semiconductrice inférieure 132 permet de réduire la distance séparant les positions proximale et distale de la section de transition modale 120.2, et donc d'obtenir un laser à cascade quantique 1 plus compact. Une augmentation de l'épaisseur de la portion semiconductrice inférieure 132 permet de diminuer sa résistance électrique et de réduire l'échauffement du laser à cascade quantique 1.

Le figure 2 est une vue schématique d'un capteur de gaz 10 comportant une puce photonique et une chambre 220 contenant un gaz à analyser.

La puce photonique intègre une matrice 200 d'au moins un laser à cascade quantique 1 tel que celui décrit en lien avec les figures 1A, 1B et 1C, et un circuit photonique. En figure 2, la matrice 200 comporte un nombre entier n supérieur ou égal à 3 de lasers à cascade quantique 1.i. Ici, seul le premier, le deuxième et le n-ième lasers à cascade quantique 1.1, 1.2, 1.n sont représentés. Dans cet exemple, chaque laser à cascade quantique 1.i émet un mode optique TM à une longueur d'onde λᵢ différente des longueurs d'ondes des modes optiques émis par les autres lasers à cascade quantique.

Le substrat 100, la couche d'encapsulation inférieure 110 et la couche structurée 115 d'un laser à cascade quantique 1.i de la matrice 200 sont communs à tous les lasers à cascade quantique 1.i, et s'étendent à toute la puce photonique, si bien que ce sont des éléments de la puce photonique qu'il n'est pas nécessaire de distinguer.

La puce photonique comprend un multiplexeur 210 de longueurs d'onde, réalisé, en partie ou en totalité, dans la couche structurée 115 ; c'est-à-dire que la couche structurée 115 comprend une partie ou la totalité du multiplexeur 210. Chaque section de propagation 120.3 d'un laser à cascade quantique 1.i est connectée optiquement à une entrée distincte du multiplexeur 210. Le multiplexeur 210 est ici un réseau de guides d'ondes (ou Arrayed Waveguide Grating, AWG, en anglais).

Le multiplexeur 210 a un guide d'onde de sortie 230 couplé optiquement à chacune des entrées du multiplexeur 210 et, par conséquent, à chacun des lasers à cascade quantique 1. Le guide d'onde de sortie 230 est également couplé optiquement à la chambre 220. Ainsi, tous les modes optiques TM émis par les lasers à cascade quantique 1.i de la matrice 200 sont combinés dans le guide d'onde de sortie 230 et se propagent jusqu'à la chambre.

Le capteur de gaz 10 comprend en outre des moyens pour détecter et/ou mesurer une absorption de photons par le gaz à une ou plusieurs longueurs d'onde λᵢ et/ou une onde acoustique générée par l'absorption par le gaz d'un ou plusieurs modes optiques TM émis par la matrice 200 de lasers à cascade quantique 1. Ainsi, une détection du gaz ou une mesure de la concentration du gaz peut être effectuée. Le capteur de gaz 10 peut par exemple être un capteur de gaz à infrarouge non dispersif ou un spectromètre photo-acoustique, par exemple tel que la chambre 220 est une cellule photo-acoustique à résonnance différentielle de Helmholtz.

Dans cet exemple, la couche structurée 115 est en silicium. La couche d'encapsulation inférieure 110 a une sous-couche de confinement en nitrure de silicium (SiN) ou en un chalcogénure. Ainsi, les guides d'onde de la puce photonique présentent un fort contraste d'indices de réfraction, et donc par conséquent, des dimensions réduites et éventuellement de faibles rayons de courbure. La puce photonique du capteur de gaz est donc compacte. La couche structurée 115 et/ou au moins un laser à cascade quantique 1 de la matrice 200 peuvent être également encapsulés d'un côté opposé à la couche d'encapsulation inférieure 110 par une couche d'encapsulation supérieure, par exemple en nitrure de silicium ou en un chalcogénure en phase amorphe.

De préférence, les guides d'onde principaux 120 des lasers à cascade quantique 1.i ont tous la même hauteur égale à une hauteur de guide commune. Avantageusement, le réseau de guides d'ondes (AWG) 210 et le guide d'onde de sortie 230 ont des hauteurs égales à la hauteur de guide commune. Ainsi, la puce photonique est plus facile à fabriquer.

La matrice 200 de lasers à cascade quantique 1.i est intégrée à la puce photonique, ainsi le capteur de gaz 10 est compact. Préférentiellement, la chambre 220 comprend une partie de la couche structurée 115, de façon à être intégrée à la puce photonique. Ainsi, des dimensions du capteur de gaz sont davantage réduites. Il peut par exemple avoir une empreinte inférieure à un rectangle de 0,75 cm par 2 cm de côtés.

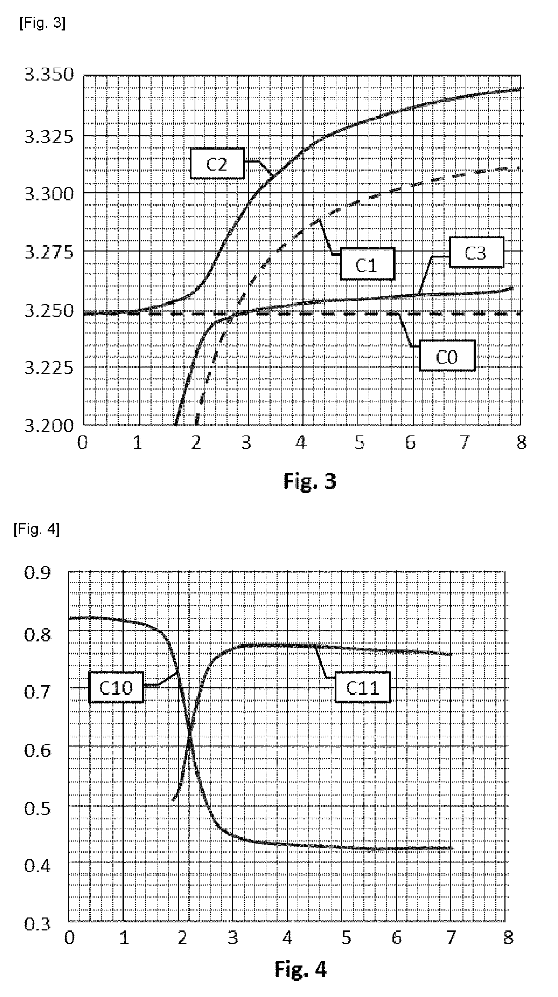

A présent, une étude paramétrique pouvant servir à l'optimisation d'un laser à cascade quantique 1 ou une matrice 200 de lasers à cascade quantique 1.i selon l'invention, va être décrite en lien avec les figures 3 à 6.

Une première étape de détermination d'une épaisseur hₜ de la couche structurée 115, mesurée parallèlement à l'axe Z, va tout d'abord être décrite.

Dans un premier temps, on fixe la largeur Wₐ de la région active 135 et de la portion semiconductrice supérieure 137 à une valeur compatible avec la propagation d'un mode optique dans le milieu amplificateur 130 à la longueur d'onde λ d'émission souhaitée. Ici, λ est égal à 4,5 µm et Wₐ est fixé à 10 µm.

Dans un deuxième temps, on fixe un rapport d'aspect du guide d'onde principal 120. Dans cette étude spécifique, le guide d'onde principal 120 est un guide d'onde en arête. Il a une base et une arête. L'arête est une partie du guide d'onde principal 120 surélevée par rapport à la base. Elle est délimitée par les cavités longilignes 155. L'épaisseur hₜ est égale à la somme des épaisseurs de la base et de l'arête.

Les cavités longilignes 155 sont ici destinées à recueillir des produits de réaction générés par un collage direct du milieu amplificateur 130 sur le guide d'onde principal 120. Elles sont remplies d'air. La hauteur h_{c} est fixée à 2 tiers (2/3) de l'épaisseur totale hₜ de la couche structurée 115.

Dans toute cette étude, le guide d'onde principal 120 est en silicium. La couche d'encapsulation inférieure 110 est en nitrure de silicium (SiN).

On détermine ensuite l'indice effectif d'un premier mode optique fondamental TM de la section de couplage 120.1, en absence du milieu amplificateur 130, pour plusieurs épaisseurs de la couche structurée 115 et plusieurs largeurs W de l'arête de la section de couplage 120.1. On repère la valeur de l'épaisseur minimale h_{t,min} de la couche structurée 115 au-delà de laquelle l'indice effectif du premier mode optique fondamental TM est supérieur ou égal à l'indice effectif d'un deuxième mode optique fondamental TM guidé par le milieu amplificateur 130 en l'absence du guide d'onde principal 120, pour une largeur W inférieure ou égale à une largeur maximale Wₘₐₓ atteignable par l'arête. Wₘₐₓ est égal à 2*Wₐ.

On choisit, pour les étapes de l'étude suivantes, une épaisseur hₜ de la couche structurée 115 strictement supérieure à h_{t,min}, préférentiellement supérieure à 1,1.h_{t,min}, voire supérieure à 1,2.h_{t,min}. Ici, h_{t,min} est sensiblement égal à 2µm, et on choisit une couche structurée 115 d'épaisseur hₜ égale 2,6 µm.

Une deuxième étape de détermination d'une largeur cible W₀ de la section de couplage 120.1 va à présent être décrite.

La figure 3 montre l'évolution des indices effectifs du premier mode optique fondamental (courbe C1), du deuxième mode optique fondamental (courbe C0), et de supermodes antisymétrique (courbe C3) et symétrique (courbe C2), en fonction de W en µm. Pour toute épaisseur de la couche structurée 115 strictement supérieure à h_{t,min}, il a été constaté que les courbes C0 et C1 encadrent la courbe C3 et l'intersectent pour une valeur W unique égale à Wₘᵢₙ. C'est ce que montre la figure 3 pour l'épaisseur hₜ de 2,6 µm. Ainsi, pour toute largeur W de l'arête supérieure ou égale à Wₘᵢₙ, des photons générés par émission stimulée dans la région active 135 peuvent exciter un mode antisymétrique qui est guidé par la structure de guidage comprenant le guide d'onde principal 120 et le milieu amplificateur 130. Ici, Wₘᵢₙ est égal à 2,3 µm. L'émission stimulée excite le supermode antisymétrique, plutôt que le supermode symétrique, parce que l'indice effectif du supermode antisymétrique est plus proche de l'indice effectif du deuxième mode optique fondamental, que l'indice effectif du supermode symétrique.

Ceci est confirmé par les résultats de simulation de la figure 4. Sur cette figure, on représente le facteur de confinement dans la région active 135 du supermode symétrique (courbe C10) et du supermode antisymétrique (courbe C11), en fonction de W en µm. On note que les courbes se croisent pour Wₘᵢₙ. Le facteur de confinement du supermode antisymétrique est strictement supérieur à celui du supermode symétrique pour toute largeur W de l'arête strictement supérieure à Wₘᵢₙ. Ainsi, si le supermode antisymétrique est préférentiellement amplifié par l'émission stimulée et éteint le supermode symétrique.

Le facteur de confinement d'un supermode dans la région active 135 est égal au rapport de l'intensité de la partie du supermode située à l'intérieur de la région active 135 sur l'intensité totale du supermode.

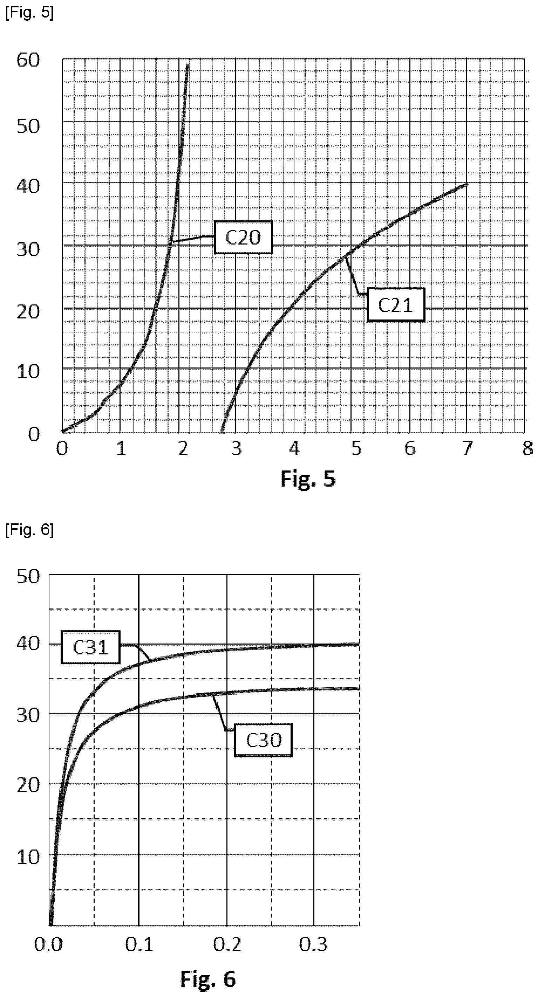

En figure 5, on a calculé la force de couplage Kᵣ du réseau de diffraction 125 pour le supermode symétrique (courbe C20) et le supermode antisymétrique (courbe C21), en fonction de W en µm. Ici, les dents du réseau de diffraction 125 s'étendent perpendiculairement à l'axe X sur toute la largeur W de la section de couplage 120.1. Pour ce calcul, la profondeur hᵣ est suffisamment grande pour que la partie évanescente du supermode antisymétrique ne se couple pas au guide d'onde principal 120 entre deux dents du réseau de diffraction 125. Ici, hᵣ est égal à h_{c} .

La force de couplage Kᵣ d'un réseau est une mesure du transfert d'énergie d'un mode ou supermode propagatif diffracté par le réseau vers un mode ou supermode contre-propagatif résultant de la diffraction, par unité de longueur. Kᵣ est donné par la formule : ${K}_{r} = \frac{2 Δ {n}_{eff}}{λ}$*,* où Δ*n_{eff}* est égal à la différence d'indices effectifs du mode ou supermode au niveau d'une dent du réseau et entre deux dents du réseau. Ainsi, Kᵣ augmente lorsque W ou hᵣ augmentent.

Dans le contexte du laser à cascade quantique de type DFB, Kᵣ est lié à la réflectivité Rᵣ du réseau de diffraction 125 par la relation *Rᵣ* = tanh²(K*ᵣLᵣ*)*,* où Lᵣ est la demi-longueur du réseau de diffraction 125 mesurée parallèlement à l'axe X. Il est considéré qu'un laser à cascade quantique de type DFB est suffisamment efficace ou a un rendement suffisant, si Rᵣ est compris entre 0,65 et 0,8, ce qui correspond à un produit Kᵣ.Lᵣ compris entre 1 et 1,4.

Il est considéré qu'une demi-longueur Lᵣ du réseau de diffraction 125 comprise entre 0,5 mm et 1 mm permet d'obtenir un laser à cascade quantique 1 suffisamment compact. Pour une demi-longueur Lᵣ égale à 0,5 mm, on va donc préférentiellement choisir des valeurs pour W et hᵣ permettant d'obtenir une force de couplage Kᵣ comprise entre 20 cm⁻¹ et 28 cm⁻¹. Pour une demi-longueur Lᵣ égale à 1 mm, on va préférentiellement choisir des valeurs pour W et hᵣ permettant d'obtenir une force de couplage Kᵣ comprise entre 10 cm⁻¹ et 14 cm⁻¹.

Au cours de la deuxième étape, on détermine à partir de la figure 5, la largeur cible W₀ de la section de couplage 120.1 dans la plage de valeurs [Wₘᵢₙ, Wₘₐₓ] précédemment établie, permettant d'obtenir une force de couplage cible K_{r,0} prédéfinie. Dans l'exemple particulier de la figure 5, une valeur W comprise entre 3,2 µm (Kᵣ = 10 cm⁻¹) et 4,8 µm (Kᵣ = 28 cm⁻¹) permet d'obtenir une force de couplage cible K_{r,0} permettant d'obtenir un laser à cascade quantique 1 compact et efficace.

Une troisième étape de détermination d'une profondeur de dents cible h_{r,0} du réseau de diffraction 125 va être décrite.

En figure 6, on a représenté la force de couplage Kᵣ (axe des ordonnées, en cm-1) en fonction de la profondeur hᵣ des dents du réseau de diffraction 125 (axe des abscisses, en µm), pour W égal à 5,75 µm (courbe C30) et W égal à 7 µm (courbe C31). Les courbes C30 et C31 sont croissantes. Il a été constaté que la force de couplage Kᵣ tend asymptotiquement vers une valeur maximale K_{r,max} lorsque hᵣ augmente. Plus exactement, l'augmentation de Kᵣ reste contenue dans une plage de variation acceptable au-delà d'une profondeur de dents minimale h_{r,min}, indépendante de la largeur W de l'arête de la section de couplage 120.1. La plage de variation acceptable est déterminée pour garantir le respect d'une spécification d'un paramètre du laser à cascade quantique 1. La spécification peut être une plage de variation de la réflectivité du réseau de diffraction 125 à respecter, par exemple égale à 2%.

On repère alors la valeur de h_{r,min}, et on détermine une profondeur de dents cible h_{r,0} strictement supérieure à h_{r,min}. Préférentiellement, la différence entre h_{r,0} et h_{r,min} est supérieure à une incertitude de profondeur subie lors d'une gravure utilisée pour former le réseau de diffraction 125, préférentiellement deux fois supérieure à l'incertitude. La profondeur de dents minimale peut dépendre de plusieurs facteurs, dont la longueur d'onde λ et l'épaisseur de la portion semiconductrice inférieure 132.

Dans cet exemple, h_{r,min} est égal à 100 nm, permettant de contenir l'augmentation de la force de couplage Kᵣ en dessous de 20 % de sa valeur pour une profondeur de dents égale à h_{r,min} ; ceci afin de garantir une réflectivité suffisante du réseau de diffraction 125. La profondeur de dents cible h_{r,0} est par exemple choisie égale à 180 nm.

Les inventeurs ont vérifié qu'une variation de la profondeur de dent hᵣ n'a sensiblement pas d'influence sur les résultats obtenus aux figures 3 et 4, dès lors que hᵣ est supérieur à h_{r,min}. Ainsi, il n'est pas nécessaire d'ajuster la valeur de la largeur cible W₀ établie lors de la deuxième étape, étant donné que les forces de couplage de la figure 5 ont été établies pour une profondeur de dents supérieure ou égale à h_{r,min}.

Lors d'une quatrième étape, à l'aide de sous-étapes conventionnelles de l'industrie de la photonique intégrée, on procède à la fabrication du laser à cascade quantique de façon à réaliser une section de couplage 120.1 de largeur W₀ et un réseau de diffraction 125 comprenant des dents de profondeur h_{r,0}, à des incertitudes de fabrication près.

L'une des sous-étapes comprend le collage direct d'un empilement de couches semiconductrices comprenant des éléments des colonnes III et V du tableau périodique des éléments, sur la couche structurée 115. Une partie au moins de l'empilement est destiné à être le milieu amplificateur 130 du laser à cascade quantique 1. Le choix d'exciter un supermode antisymétrique de la structure de guidage, permet d'obtenir une largeur W de la section de couplage 120.1 suffisamment grande pour que le fonctionnement du laser à cascade quantique 1 ne soit pas impacté par une incertitude d'alignement de l'empilement par rapport à la couche structurée 115, lors de cette sous-étape de collage direct.

La largeur W de la section de couplage 120.1 est également suffisamment grande pour établir un transfert thermique efficace du milieu amplificateur 130 vers le guide d'onde principal 120, lorsque le laser à cascade quantique 1 est en fonctionnement.

Il a été constaté par les inventeurs que plus la largeur W de la section de couplage 120.1 est grande, moins une incertitude sur la valeur de W résultant de la fabrication du laser à cascade quantique 1 est susceptible d'impacter la force de couplage Kᵣ du supermode **antisymétrique** avec le réseau de diffraction 125. Dans tous les cas, une variation de la largeur W induit une moindre erreur de la force de couplage Kᵣ obtenue par rapport à la force de couplage cible K_{r,0} avec une structure de guidage configurée pour guider un supermode antisymétrique, comparativement à une structure de guidage configurée pour guider un supermode symétrique.

Enfin, comme la largeur W de la section de couplage 120.1 est grande et que le supermode antisymétrique est de type TM, ce dernier n'est que faiblement diffracté par la rugosité des flancs de la section de couplage 120.1. Ceci permet de réduire des pertes intra-cavité du laser à cascade quantique 1.

Des modes de réalisation particuliers viennent d'être décrits. Différentes variantes et modifications apparaîtront à l'homme du métier.

## Revendications

1. Laser à cascade quantique (1) pour émettre un mode optique polarisé de type transverse magnétique à une longueur d'onde λ comprise entre 3 µm et 15 µm, comportant :
∘ un milieu amplificateur (130) semiconducteur comportant une région active (135),
∘ un guide d'onde principal (120) s'étendant parallèlement à la région active (135) et comportant :
• une section de couplage (120.1) en contact avec le milieu amplificateur (130), comprenant un réseau de diffraction (125) configuré pour générer une rétroaction distribuée dans le milieu amplificateur (130) à la longueur d'onde λ,
• une section de propagation (120.3) séparée du milieu amplificateur (130), apte à guider le mode optique,
le laser à cascade quantique (1) étant tel que
∘ la section de couplage (120.1) a une largeur W supérieure ou égale à une largeur minimale Wₘᵢₙ à partir de laquelle un supermode antisymétrique se propageant dans une structure de guidage du laser comprenant le milieu amplificateur (130) et le guide d'onde principal (120), a un facteur de confinement dans la région active (135) strictement supérieur aux facteurs de confinement dans la région active (135) des modes optiques susceptibles d'être guidés par la structure de guidage,
∘ le guide d'onde principal (120) comporte un coeur en un matériau à base d'atomes de la colonne IV A du tableau périodique des éléments et une sous-couche de confinement en nitrure de silicium ou en un chalcogénure, d'un côté du guide d'onde principal (120) opposé au milieu amplificateur (130).

2. Laser à cascade quantique (1) selon la revendication 1, dans lequel le guide d'onde principal (120) comporte en outre une section de transition modale (120.2) en contact avec le milieu amplificateur (130), s'étendant de la section de couplage (120.1) à la section de propagation (120.3), se rétrécissant progressivement de la section de couplage (120.1) à la section de propagation (120.3) de façon à assurer une conversion modale entre le supermode antisymétrique et le mode optique.

3. Laser à cascade quantique (1) selon la revendication 1 ou 2, dans lequel le milieu amplificateur (130) comprend une portion semiconductrice inférieure (132) en contact avec le guide d'onde principal (120) et une portion semiconductrice supérieure (137), toutes deux dopées N, la région active (135) étant intercalée entre les portions semiconductrices inférieure et supérieure (132, 137).

4. Laser à cascade quantique (1) selon la revendication 3, dans lequel la région active (135) et la portion semiconductrice supérieure (137) ont, chacune et ensemble, une forme de parallélépipède droit.

5. Laser à cascade quantique (1) selon l'une quelconque des revendications précédentes, dans lequel le réseau de diffraction (125) comporte des dents, chacune de profondeur hᵣ, la largeur W et la profondeur hᵣ étant telles que le réseau de diffraction (125) présente une force de couplage Kᵣ comprise entre 5 cm⁻¹ et 100 cm⁻¹, de préférence comprise entre 10 cm⁻¹ et 28 cm⁻¹.

6. Laser à cascade quantique (1) selon l'une quelconque des revendications précédentes, dans lequel le réseau de diffraction (125) comporte des dents, chacune de profondeur hᵣ, la profondeur hᵣ étant supérieure à une profondeur minimale h_{r,min} permettant de contenir une variation d'une force de couplage Kᵣ du réseau de diffraction (125) en fonction de hᵣ dans une plage de variation acceptable déterminée pour garantir le respect d'une spécification du laser à cascade quantique (1).

7. Capteur de gaz (10) comprenant une puce photonique, une chambre (220) couplée optiquement à la puce photonique, la puce photonique comprenant un laser à cascade quantique (1) selon l'une quelconque des revendications précédentes, intégré dans la puce photonique.

8. Capteur de gaz (10) selon la revendication 7, dans lequel le laser à cascade quantique (1) est un élément d'une matrice (200) de plusieurs lasers à cascade quantique (1.i) selon l'une quelconque des revendications 1 à 6, chaque laser à cascade quantique (1.i) de la matrice (200) étant configuré pour émettre un mode optique à une longueur d'onde λᵢ différente des longueurs d'ondes des modes optiques émis par les autres lasers à cascade quantique (1.i) de la matrice (200).

9. Capteur de gaz (10) selon la revendication 8, dans lequel la puce photonique comporte un multiplexeur (210) de longueurs d'onde et une couche structurée (115), et tel que :
∘ chaque section de propagation (120.3) d'un laser à cascade quantique (1.i) de la matrice (200) est connectée optiquement à une entrée distincte du multiplexeur (210),
∘ le multiplexeur (210) comprend un guide d'onde de sortie (230) couplé optiquement à chacune des entrées du multiplexeur (210), et à la chambre (220),
∘ la couche structurée (115) comprend le multiplexeur (210), le guide d'onde de sortie (230) et chacun des guides d'onde principaux (120) des laser à cascade quantique (1.i) de la matrice (200).

10. Capteur de gaz selon la revendication 9, dans lequel la couche structurée (115) comprend en outre une partie au moins de la chambre (220).

11. Capteur de gaz selon l'une quelconque des revendications 7 à 10, dans lequel la chambre (220) est une cellule photo-acoustique à résonnance différentielle de Helmholtz.

## Patentansprüche

1. Quantenkaskadenlaser (1) zum Aussenden einer polarisierten, transversalmagnetischen optischen Mode mit einer Wellenlänge λ zwischen 3 µm und 15 µm, umfassend:
∘ ein Halbleiter-Verstärkermedium (130) mit einem aktiven Bereich (135),
∘ einen Hauptwellenleiter (120), der sich parallel zu dem aktiven Bereich (135) erstreckt und umfasst:
• einen Kopplungsabschnitt (120.1), der mit dem Verstärkermedium (130) in Kontakt steht, umfassend ein Beugungsgitter (125), das so eingerichtet ist, dass es eine in dem Verstärkermedium (130) mit der Wellenlänge λ verteilte Rückkopplung erzeugt,
• einen von dem Verstärkermedium (130) getrennten Ausbreitungsabschnitt (120.3), der geeignet ist, die optische Mode zu führen,
wobei der Quantenkaskadenlaser (1) so ist, dass
∘ der Kopplungsabschnitt (120.1) eine Breite W aufweist, die größer oder gleich einer Mindestbreite Wₘᵢₙ ist, ab der sich eine unsymmetrische Supermode in einer Laserführungsstruktur ausbreitet, die das Verstärkermedium (130) und den Hauptwellenleiter (120) umfasst, einen Eingrenzungsfaktor in dem aktiven Bereich (135) aufweist, der strikt höher ist als die Eingrenzungsfaktoren in dem aktiven Bereich (135) der optischen Moden, die von der Führungsstruktur geführt werden können,
∘ der Hauptwellenleiter (120) auf einer dem Verstärkermedium (130) gegenüberliegenden Seite des Hauptwellenleiters (120) einen Kern aus einem atombasierten Material der Gruppe IV A des Periodensystems der Elemente und eine Einschlussunterschicht aus Siliziumnitrid oder einem Chalkogenid aufweist.

2. Quantenkaskadenlaser (1) nach Anspruch 1, wobei der Hauptwellenleiter (120) ferner einen modalen Übergangsabschnitt (120.2) aufweist, der in Kontakt mit dem Verstärkermedium (130) steht, der sich von dem Kopplungsabschnitt (120.1) zu dem Ausbreitungsabschnitt (120.3) erstreckt und sich allmählich von dem Kopplungsabschnitt (120.1) zu dem Ausbreitungsabschnitt (120.3) verengt, um eine modale Umwandlung zwischen der unsymmetrischen Supermode und der optischen Mode zu gewährleisten.

3. Quantenkaskadenlaser (1) nach Anspruch 1 oder 2, wobei das Verstärkermedium (130) einen unteren Halbleiterabschnitt (132) umfasst, der in Kontakt mit dem Hauptwellenleiter (120) und einem oberen Halbleiterabschnitt (137) steht, wobei beide N-dotiert sind, wobei der aktive Bereich (135) zwischen dem unteren und dem oberen Halbleiterabschnitt (132, 137) eingefügt ist.

4. Quantenkaskadenlaser (1) nach Anspruch 3, wobei der aktive Bereich (135) und der obere Halbleiterabschnitt (137) jeweils zusammen eine gerade Quaderform aufweisen.

5. Quantenkaskadenlaser (1) nach einem der vorhergehenden Ansprüche, wobei das Beugungsgitter (125) Zähne mit jeweils einer Tiefe hᵣ aufweist, wobei die Breite W und die Tiefe hᵣ so sind, dass das Beugungsgitter (125) eine Kopplungskraft Kᵣ zwischen 5 cm⁻¹ und 100 cm⁻¹, vorzugsweise zwischen 10 cm⁻¹ und 28 cm⁻¹, aufweist.

6. Quantenkaskadenlaser (1) nach einem der vorhergehenden Ansprüche, wobei das Beugungsgitter (125) Zähne mit jeweils einer Tiefe hᵣ aufweist, wobei die Tiefe hᵣ größer ist als eine Mindesttiefe h_{r,min}, die es ermöglicht, eine Änderung einer Kopplungskraft Kᵣ des Beugungsgitters (125) als Funktion von hᵣ innerhalb eines bestimmten akzeptablen Variationsbereichs zu erhalten, um sicherzustellen, dass eine Spezifikation des Quantenkaskadenlasers (1) erfüllt wird.

7. Gassensor (10), der einen photonischen Chip und eine Kammer (220) umfasst, die optisch mit dem photonischen Chip gekoppelt ist, wobei der photonische Chip einen Quantenkaskadenlaser (1) nach einem der vorhergehenden Ansprüche umfasst, der in den photonischen Chip integriert ist.

8. Gassensor (10) nach Anspruch 7, wobei der Quantenkaskadenlaser (1) ein Element einer Matrix (200) mehrerer Quantenkaskadenlaser (1.i) nach einem der Ansprüche 1 bis 6 ist, wobei jeder Quantenkaskadenlaser (1.i) der Matrix (200) so eingerichtet ist, dass er eine optische Mode mit einer Wellenlänge λ_{¡} aussendet, die sich von den Wellenlängen der von den anderen Quantenkaskadenlasern (1.i) der Matrix (200) ausgesendeten optischen Moden unterscheidet.

9. Gassensor (10) nach Anspruch 8, wobei der photonische Chip einen Wellenlängenmultiplexer (210) und eine strukturierte Schicht (115) umfasst, und wobei:
∘ jeder Ausbreitungsabschnitt (120.3) eines Quantenkaskadenlasers (1.i) der Matrix (200) optisch mit einem separaten Eingang des Multiplexers (210) verbunden ist,
∘ der Multiplexer (210) einen Ausgangswellenleiter (230) umfasst, der optisch mit jedem der Eingänge des Multiplexers (210) und der Kammer (220) gekoppelt ist,
∘ die strukturierte Schicht (115) den Multiplexer (210), den Ausgangswellenleiter (230) und jeden der Hauptwellenleiter (120) der Quantenkaskadenlaser (1.i) der Matrix (200) umfasst.

10. Gassensor nach Anspruch 9, wobei die strukturierte Schicht (115) ferner mindestens einen Teil der Kammer (220) umfasst.

11. Gassensor nach einem der Ansprüche 7 bis 10, wobei die Kammer (220) eine fotoakustische Zelle mit differenzieller Helmholtz-Resonanz ist.

## Claims

1. Quantum cascade laser (1) for emitting a transverse magnetic polarized optical mode at a wavelength λ between 3 µm and 15 µm, having:
∘ a semiconductor gain medium (130) including an active region (135),
∘ a main waveguide (120) extending parallel to the active region (135) and including:
• a coupling section (120.1) in contact with the gain medium (130), comprising a diffraction grating (125) configured to generate distributed feedback in the gain medium (130) at the wavelength λ,
• a propagation section (120.3) separated from the gain medium (130), capable of guiding the optical mode,
the quantum cascade laser (1) being such that
∘ the coupling section (120.1) has a width W greater than or equal to a minimum width Wₘᵢₙ from which an antisymmetric supermode propagating in a laser guiding structure comprising the gain medium (130) and the main waveguide (120), has a confinement factor in the active region (135) strictly greater than the confinement factors in the active region (135) of the optical modes likely to be guided by the guiding structure,
∘ the main waveguide (120) includes a core made of a material based on Group IV A atoms of the Periodic Table of Elements and a silicon nitride or chalcogenide confinement sublayer, on a side of the main waveguide (120) opposite to the gain medium (130).

2. Quantum cascade laser (1) according to Claim 1, wherein the main waveguide (120) further includes a modal transition section (120.2) in contact with the gain medium (130), extending from the coupling section (120.1) to the propagation section (120.3), gradually narrowing from the coupling section (120.1) to the propagation section (120.3) so as to cause a modal conversion between the antisymmetric supermode and the optical mode.

3. Quantum cascade laser (1) according to Claim 1 or 2, wherein the gain medium (130) comprises a lower semiconductor portion (132) in contact with the main waveguide (120) and an upper semiconductor portion (137), both N-doped, the active region (135) being interposed between the lower and upper semiconductor portions (132, 137).

4. Quantum cascade laser (1) according to Claim 3, wherein the active region (135) and the upper semiconductor portion (137) each and together have a rectangular parallelepiped shape.

5. Quantum cascade laser (1) according to any one of the preceding claims, wherein the diffraction grating (125) includes teeth, each with a depth hᵣ, the width W and the depth hᵣ being such that the diffraction grating (125) has a coupling strength Kᵣ between 5 cm⁻¹ and 100 cm⁻¹, preferably between 10 cm⁻¹ and 28 cm⁻¹.

6. Quantum cascade laser (1) according to any one of the preceding claims, wherein the diffraction grating (125) includes teeth, each with a depth hᵣ, the depth hᵣ being greater than a minimum depth h_{r,min} enabling a variation of a coupling strength Kᵣ of the diffraction grating (125) as a function of hᵣ to be contained within an acceptable variation range determined to guarantee compliance with a specification of the quantum cascade laser (1).

7. Gas sensor (10) comprising a photonic chip, a chamber (220) optically coupled to the photonic chip, the photonic chip comprising a quantum cascade laser (1) according to any one of the preceding claims, integrated into the photonic chip.

8. Gas sensor (10) according to Claim 7, wherein the quantum cascade laser (1) is an element of an array (200) of a plurality of quantum cascade lasers (1.i) according to any one of Claims 1 to 6, each quantum cascade laser (1.i) of the array (200) being configured to emit an optical mode at a wavelength λᵢ different from the wavelengths of the optical modes emitted by the other quantum cascade lasers (1.i) of the array (200).

9. Gas sensor (10) according to Claim 8, wherein the photonic chip includes a wavelength multiplexer (210) and a structured layer (115), and such as:
∘ each propagation section (120.3) of a quantum cascade laser (1.i) of the array (200) is optically connected to a separate input of the multiplexer (210),
∘ the multiplexer (210) comprises an output waveguide (230) optically coupled to each of the inputs of the multiplexer (210), and to the chamber (220),
∘ the structured layer (115) comprises the multiplexer (210), the output waveguide (230) and each of the main waveguides (120) of the quantum cascade lasers (1.i) of the array (200).

10. Gas sensor according to Claim 9, wherein the structured layer (115) further comprises at least a portion of the chamber (220).

11. Gas sensor according to any one of Claims 7 to 10, wherein the chamber (220) is a differential Helmholtz resonant photoacoustic cell.
